Europäisches Patentamt

European Patent Office

Office européen des brevets

(19)

(11) Veröffentlichungsnummer: **0 038 583**
**B1**

(12) EUROPÄISCHE PATENTSCHRIFT

(45) Veröffentlichungstag der Patentschrift:
09.05.84

(51) Int. Cl.³: **H 01 H 9/20,** H 05 K 7/14

(21) Anmeldenummer: 81200339.0

(22) Anmeldetag: 27.03.81

(54) Sperrvorrichtung für einen Schalter, der in einem aus einem Gehäuse ausziehbaren Baugruppenträger eingebaut ist.

(30) Priorität: 21.04.80 CH 3048/80

(43) Veröffentlichungstag der Anmeldung:
28.10.81 Patentblatt 81/43

(45) Bekanntmachung des Hinweises auf die Patenterteilung:
09.05.84 Patentblatt 84/19

(84) Benannte Vertragsstaaten:
CH DE LI SE

(56) Entgegenhaltungen:
AU - B - 408 413
FR - A - 2 403 636
GB - A - 2 015 828
US - A - 3 297 839
US - A - 3 919 507
US - A - 3 932 716
US - A - 4 071 722

(73) Patentinhaber: **BBC Aktiengesellschaft Brown, Boveri & Cie., Haselstrasse, CH-5401 Baden (CH)**

(72) Erfinder: **Burkard, Henle, Waldmatt 4, CH-5242 Birr (CH)**

## Beschreibung

Die Erfindung bezieht sich auf eine Verriegelungsvorrichtung gemäss dem ersten Teil des Anspruchs 1.

Eine solche Einrichtung ist z.B. aus der US-A Nr. 4071722 bekannt.

Bekanntlich finden in verschiedensten Maschinen und Anlagen in vermehrtem Masse elektronische Steuerungs- und Regeleinrichtungen Verwendung. Allgemein hat sich hierfür aus Gründen der Servicefreundlichkeit der modulare Aufbau mittels austauschbarer Baugruppenträger bewährt. Dabei stellt sich das Problem, auf einfache Weise möglichst einwandfreie mechanische und elektrische Verbindungen der Baugruppenträger mit einem meist grösseren Apparategehäuse zu schaffen, welche den hohen Sicherheitsanforderungen genügen und trotzdem möglichst keine Werkzeuge beim Austausch erfordern. Anwendung finden hierfür Baugruppenträger mit Verriegelungsvorrichtungen (vgl. DE-A Nr. 2810572) sowie Ein- und Ausziehvorrichtungen (z.B. DE-A Nr. 2814991).

In der Praxis kommt es jedoch häufig vor, dass insbesondere komplexe Anlagen nicht oder nur unter Einbezug eines hohen Sicherheitsrisikos abgeschaltet werden können. Dies bedingt ein Austauschen von beispielsweise defekten oder der Wartung zuzuführenden Baugruppenträgern während des Betriebes. Nun bestehen jedoch häufig Verknüpfungen im Signalfluss und/oder der Speisung der einzelnen Baugruppenträger zueinander oder zu zentralen Einheiten. Daraus ergibt sich die Forderung, dass Baugruppenträger nicht oder nur erst nach Abschaltung oder Zuschaltung von Speisespannungen und/oder Signalquellen entfernt bzw. eingebaut werden dürfen. Grundsätzlich besteht hierfür die Möglichkeit, logische Verknüpfungsschaltungen vorzusehen, welche jedoch den schaltungstechnischen Aufwand derartiger Anlagen erhöhen und zudem selbst wieder zu Betriebsstörungen führen können.

Es ist daher Aufgabe der Erfindung, einen Zwangsmechanismus zu schaffen, welcher bei auf den Frontplatten von Baugruppenträgern vorhandenen Schaltern eine Fehlbetätigung im Zusammenhang mit dem Ein- oder Ausbau des Baugruppenträgers verhindert.

Erfindungsgemäss wird diese Aufgabe durch die Merkmale gemäss dem zweiten Teil des Anspruchs 1 gelöst.

Diese Lösung zeichnet sich insbesondere durch ihre Einfachheit aus und lässt sich je nach mechanischer Ausbildung des Baugruppenträgers und/oder des Schalters z.B. eines Drehknopfschalters, Kippschalters oder Drucktastenschalters entsprechend anwenden.

Im abhängigen Anspruch 2 wird eine vorteilhafte Weiterbildung der Erfindung beschrieben.

Die Variante nach Anspruch 2 bewirkt eine einfache und sichere Anzeige des Schaltzustandes.

Im folgenden wird an Hand von schematischen Zeichnungen eine bevorzugte Ausführungsform einer Sperrvorrichtung dargestellt:

Es zeigt

Fig. 1  einen Baugruppenträger mit Sperriegel im arretierten Zustand des frontseitigen Schalters,

Fig. 2  eine Teilansicht von Fig. 1 in Schnittdarstellung und

Fig. 3  die Teilansicht nach Fig. 2 im nicht arretierten Zustand des frontseitigen Schalters.

Im sämtlichen Figuren sind gleiche Teile mit gleichen Bezugsziffern versehen.

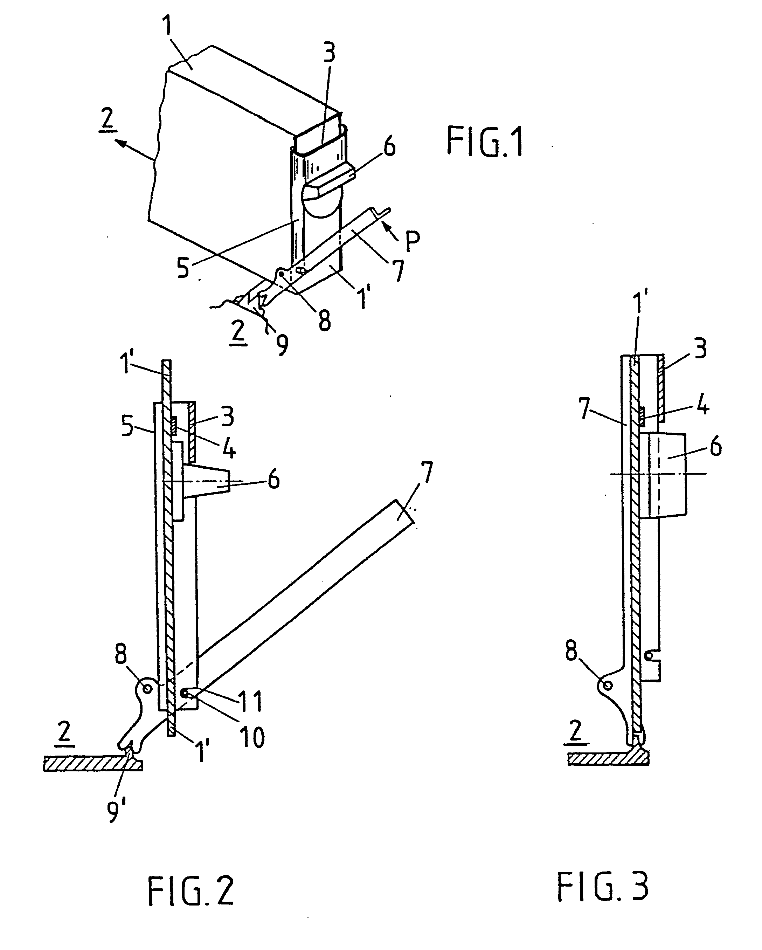

Gemäss Fig. 1 ist mit 1 ein üblicher genormter Baugruppenträger bezeichnet. Dieser Baugruppenträger ist teilweise in ein Apparategehäuse 2 eingeschoben. Stirnseitig weist der Baugruppenträger 1 eine Frontplatte 1' auf, auf welcher ein Betätigungsteil 6 eines Schalters herausragt. Das Betätigungsteil 6 ist einseitig formschlüssig durch einen Sperriegel 3 arretiert. Der Sperriegel 3 ist gelenkig und drehbar mit einem in einem Drehpunkt 8 gelagerten Einführungshebel 7 verbunden. Das kürzere Ende des Einführungshebels 7 greift in einen Zahn eines Zahnstangenabschnittes 9 ein.

Durch eine am Einführungshebel 7 angreifende Kraft P bewegt sich der Baugruppenträger 1 in Pfeilrichtung in das Innere des Apparategehäuses und bewirkt hier ein Zusammenfügen der elektrischen Kontakte eines nicht dargestellten, handelsüblichen Steckers mit seinem Gegenstück (z.B. Steckerleiste). Dadurch wird gleichzeitig der Sperrigel 3 hochgehoben, so dass der Betätigungsteil 6 des Schalters frei drehbar ist.

Dementsprechend kann zum Beispiel ein Gerät nur bei sämtlichen eingerasteten Steckerkontakten eingeschaltet werden oder eine elektrische Verbindung zu weiteren zentralen oder peripheren Geräten hergestellt werden.

In den Schnittdarstellungen Fig. 2 und 3 ist eine optische Anzeige 4 ersichtlich, welche im arretierten Zustand (Fig. 2) abgedeckt und im nicht arretierten Zustand des Schalters (Fig. 3) zumindest teilweise sichtbar ist.

Die optische Anzeige 4 kann aktiv (lichtemittierend) oder auch passiv (lichtreflektierend) — im einfachsten Fall ein Farbfleck, sein.

Die Konstruktion des Einführungshebels 7 mit seinem endseitigen Eingriff in einen Zahn 9' ist an sich bekannt (DE-A Nr. 2814991).

Zusätzlich ist hier im Einführungshebel 7 ein Bolzen 10 angebracht, der in einer Nut 11 einer Seitenführung 5 des Sperriegels 3 gelagert ist und diesen je nach Stellung des Einführungshebels 7 mehr oder weniger hochhebt.

Wie aus den Fig. 1 bis 3 ersichtlich ist, handelt es sich hier um einen üblichen Drehschalter, welcher ohne jede Modifikation eingebaut ist.

Die Konstruktion lässt sich leicht an die meisten handelsüblichen Schaltertypen anpassen. Ebenso kann der Sperriegel 3 entsprechend der jeweiligen Konstruktion des Baugruppenträgers 1 bzw. seiner Frontplatte 1' angepasst werden.

Die erfindungsgemässe Vorrichtung lässt sich in den verschiedensten elektrischen und elektronischen Geräten und Anlagen anwenden. Insbesondere erbringt sie in der Sicherheits- und Schutztechnik eine Erhöhung der Betriebssicherheit.

## Patentansprüche

1. Vorrichtung zum Verriegeln eines in die Frontplatte (1') eines Baugruppenträgers (1) eingebauten Schalters mit einem ein Betätigungsteil (6) des Schalters beim Ein- und Ausziehen des Baugruppenträgers (1) aus einem Apparategehäuse (2) blockierenden Sperriegel (3), dadurch gekennzeichnet, dass der Sperriegel (3) durch einen am Baugruppenträger (1) drehbar gelagerten und auf dem Apparategehäuse (2) abgestützten Hebel (7) bewegbar ist und eine in einer Seitenführung (5) befindliche Nut (11) aufweist, in welche ein am Hebel (7) angebrachter Bolzen (10) eingreift.

2. Vorrichtung nach Anspruch 1, dadurch gekennzeichnet, dass der Sperriegel (3) längs der Oberfläche der Frontplatte (1') verschieblich angeordnet ist und im arretierten Zustand des Schalters eine optische Anzeige (4) abdeckt.

## Revendications

1. Dispositif pour verrouiller un interrupteur incorporé dans le panneau frontal (1') d'un châssis de sous-ensemble (1) comportant un verrou d'arrêt (3) bloquant un organe de manœuvre (6) de l'interrupteur lors de l'insertion et de l'extraction du châssis de sous-ensemble (1) d'un habillage d'appareil (2), caractérisé en ce que le verrou d'arrêt (3) peut être déplacé par un levier (7) monté à pivot sur le châssis de sous-ensemble (1) et prenant appui sur l'habillage (2) et présente une encoche (11) dans un guide latéral (5) dans laquelle s'engage un ergot (10) prévu sur le levier (7).

2. Dispositif suivant la revendication 1, caractérisé en ce que le verrou d'arrêt (3) est monté de manière à pouvoir coulisser le long de la surface du panneau frontal (1') et, dans l'état de blocage de l'interrupteur, il masque une indication optique (4).

## Claims

1. Device for locking a switch, built into the front plate (1') of a sub-rack (1), by means of a locking bolt (3) which blocks an actuating part (6) of the switch when the sub-rack (1) is inserted into or withdrawn out of an appliance housing (2), characterised in that the locking bolt (3) can be moved by a lever (7), which is rotatably mounted on the sub-rack (1) and is supported on the appliance housing (2), and has a groove (11) which is located in a lateral guide (5) and in which a bolt (10) fitted on the lever (7) engages.

2. Device according to Claim 1, characterised in that the locking bolt (3) is arranged to be displaceable along the surface of the front plate (1') and, in the locked state of the switch, covers an optical display (4).

FIG.1

FIG.2

FIG.3